Europäisches Patentamt

European Patent Office

Office européen des brevets

(19)

(11) Veröffentlichungsnummer: **0 169 492**
**B1**

(12) **EUROPÄISCHE PATENTSCHRIFT**

(45) Veröffentlichungstag der Patentschrift: **06.02.91**

(51) Int. Cl.⁵: **G 03 F 1/10**

(21) Anmeldenummer: **85108928.4**

(22) Anmeldetag: **17.07.85**

(54) **Verfahren und Material zur Herstellung mehrfarbiger Reproduktionen.**

(30) Priorität: 25.07.84 JP 156195/84
25.07.84 JP 156196/84

(43) Veröffentlichungstag der Anmeldung:
**29.01.86 Patentblatt 86/05**

(45) Bekanntmachung des Hinweises auf die
Patenterteilung:
**06.02.91 Patentblatt 91/06**

(84) Benannte Vertragsstaaten:
**DE FR GB**

(56) Entgegenhaltungen:
**EP-A-0 076 565**
**EP-A-0 117 013**
**FR-A-1 238 262**
**FR-A-2 175 955**
**US-A-3 432 297**

(73) Patentinhaber: **HOECHST JAPAN KABUSHIKI**
**KAISHA**
**New Hoechst Building No. 10-16, 8-chome**
**Akasaka Minato-ku Tokyo (JP)**

(72) Erfinder: **Itoh, Kunio**
**1429-404, Hatsuzawa-cho**
**Hachioji-shi Tokyo (JP)**

(74) Vertreter: **Euler, Kurt Emil, Dr. et al**
**KALLE Niederlassung der Hoechst AG**
**Rheingaustrasse 190 Postfach 3540**
**D-6200 Wiesbaden 1 (DE)**

EP 0 169 492 B1

# Beschreibung

Die Erfindung betrifft ein Verfahren zur Herstellung mehrfarbiger Reproduktionen sowie ein lichtempfindliches Material zur Durchführung des Verfahrens.

Es ist ein Verfahren zur Herstellung von mehrfarbigen Reproduktionen für den Einsatz in Bildröhren o. a. bekannt, bei dem mittels Photolithographie ein Rasterbild in einer auf einen Träger aufgebrachten Proteinschicht erzeugt und das Rasterbild eingefärbt wird. Die einzelnen Schritte eines derartigen bekannten Verfahrens sind jedoch kompliziert. Außerdem müssen die Erzeugung eines Rasterbilds auf der freigelegten Proteinschicht und das Einfärben für jede Farbe wiederholt werden. Um eine dreifarbige Reproduktion aus den Farben Rot, Grün und Blau zu erhalten, müssen die beschriebenen Verfahrensschritte, einschließlich des Aufbringens einer Photoresistschicht, dreimal wiederholt werden. Außerdem muß nach der Erzeugung jedes einzelnen farbigen Bildes eine Schutzschicht aufgetragen werden, um bei der nächsten Einfärbung eine reine Farbe zu erzielen.

Ohne Aufbringen der Schutzschicht wird die angefärbte Proteinschicht gequollen und angelöst und, wie erwähnt, bei der nächsten Einfärbung wiederum angefärbt, so daß man kein mehrfarbiges Bild in reinen Farbtönen erhält.

Für die Herstellung einer farbigen Reproduktion für Flüssigkristallanzeigeelemente wird ein Verbund aus einem Träger verwendet, auf den eine Proteinschicht und darüber eine Photoresistschicht aufgebracht ist. Zur Erzeugung eines Reliefbilds unter Freilegen der Proteinschicht wird die Photoresistschicht bildmäßig belichtet und entwickelt, sodann wird die erhaltene freigelegte Proteinschicht mit einem sauren Farbstoff unter Erwärmen eingefärbt.

Wie erwähnt, neigt die Proteinschicht jedoch dazu, während des Einfärbens anzuquellen und angelöst zu werden. Ein Nachteil dieses Verfahrens besteht also darin, daß unklare, verlaufene Bildelemente entstehen. Es wird angenommen, daß sich Risse bilden, die in den Randbereichen der als Maske für das Einfärben dienenden Photoresistschablone entstehen und vermutlich durch das Anquellen der Proteinschicht verursacht werden. Auch wird die Haftung zwischen der Proteinschicht und der photoresistschicht gelockert, was vermutlich durch das Anlösen der Proteinschicht verursacht wird.

Zusammenfassend kann man daher feststellen, daß beim Einfärben einer Proteinschicht alle Verfahrensschritte, einschließlich des Aufbringens der proteinschicht, wiederholt werden müssen, während beim stufenweisen Einfärben einer einzigen Proteinschicht unklare, verwischte Farbstellen entstehen.

In der EP-A 0 076 565 wird eine negativ arbeitende lichtempfindliche Schicht beschrieben, die auf eine Gelatineschicht aufgetragen ist, die gleichmäßig durch einen Farbstoff angefärbt ist und zudem ein Bisulfit eines Aldehyds enthält.

Die einmalig durchgeführte bildmäßige Belichtung führt dazu, daß die Schicht an den belichteten Stellen erhärtet wird und der Entwickler auch die Nichtbildstellen der darunter befindlichen Gelatineschicht härtet. Nach dem Strukturieren der Gelatineschicht wird die Photoresistschicht vollständig entfernt.

Die FR-A 2 175 955 beschreibt ein negativ arbeitendes lichtempfindliches Material, das als lichtempfindliche Verbindung ein Kondensationsharz aus p-Aminodiphenyldiazoniumsalz und Formaldehyd enthält. Als Bindemittel dieser lichtempfindlichen Schicht wird neben Polyvinylalkohol auch Gelatine genannt. Die genannte Schicht enthält keinen Farbstoff.

Aufgabe der Erfindung ist es, ein Verfahren zur Herstellung mehrfarbiger Reproduktionen zu schaffen, das keine erneuten Beschichtungsschritte erfordert und das klare mehrfarbige Bilder in reinen Farbtönen liefert.

Gegenstand der Erfindung ist ein Verfahren zur Herstellung eines mehrfarbigen Bilds, bei dem ein lichtempfindliches Material aus einem Schichtträger, einer Proteinschicht und einer positiv arbeitenden Photoresistschicht, die auf der Proteinschicht liegt, bildmäßig belichtet und durch Auswaschen der belichteten Bereiche der Photoresistschicht entwickelt wird, die freigelegten Bereiche der Proteinschicht mit einer Farbstofflösung eingefärbt werden, die verbliebene photoresistschablone mindestens ein weiteres Mal bildmäßig belichtet und entwickelt wird und die hierbei freigelegten Bereiche der Proteinschicht mit einer Lösung eines anderen Farbstoffs eingefärbt werden.

Das erfindungsgemäße Verfahren ist dadurch gekennzeichnet, daß das Protein entweder vor dem Aufbringen oder nach dem Entwickeln der Photoresistschicht und vor dem Einfärben oder aber nach dem Einfärben mit Formaldehyd oder einer Formaldehyd freisetzenden Verbindung behandelt wird.

Erfindungsgemäß wird ferner ein lichtempfindliches Material zur Durchführung des vorstehenden Verfahrens vorgeschlagen, das aus einem Schichtträger besteht, der eine mit Formaldehyd behandelte Proteinschicht und darüber eine positiv arbeitende Photoresistschicht trägt.

Bei einer ersten Ausführungsform des erfindungsgemäßen Verfahrens wird zur Herstellung einer farbigen Reproduktion ein Verbund verwendet, der aus einem Träger besteht, auf den zunächst eine mit Formaldehyd behandelte Proteinschicht und darüber eine Photoresistschicht aufgetragen wurde. Im allgemeinen besteht der Träger aus anorganischen Stoffen, wie Glas, Quarz oder Aluminiumoxid oder aus Folien aus organischen hochmolekularen Substanzen, zum Beispiel aus Polyvinylchlorid, Polyethylenterephthalat, Polymethacrylaten oder Polycarbonaten. Die Oberfläche des Trägers kann noch vorbehandelt werden, z. B. durch Sputtern mit Sauerstoff oder dgl. oder durch Aufbringen einer Grundierschicht aus einem organischen Silan, wodurch die Haftung zwischen dem Träger und der darüber aufgetragenen Proteinschicht erhöht wird. Die Trägeroberfläche kann auch noch mit einer Schicht zur Verbesserung der optischen Eigenschaften versehen werden. Es können auch Träger verwendet werden, die zur Verwendung als Elektroden oberflächlich leitfähig gemacht worden sind, z. B. mit Indium-Zinn-Oxidschichten. Auf den Träger wird eine proteinschicht aufgetragen. Dabei kann jedes Protein eingesetzt werden, das färbbare -CONH-Gruppen enthält und wasserlöslich ist. Gelatine ist ein geeignetes Protein.

Im Rahmen der Erfindung können eine Reihe von Verfahren zur Erzeugung der mit Formaldehyd behandelten Proteinschicht angewandt werden, z. B.: (1.) ein Verfahren, bei dem eine durch Zugabe von Formaldehyd zu einer Proteinlösung erhaltene Protein-Formaldehyd-Lösung aufgetragen wird; (2.) ein Verfahren, bei dem eine Formaldehyd enthaltene Proteinlösung und eine formaldehydfreie Proteinlösung verwendet werden und bei dem zuerst die formaldehydfreie Proteinlösung und darüber die Formaldehyd enthaltende Proteinlösung aufgetragen wird, wobei die zweite Lösung vor oder nach dem Trocknen der ersten aufgetragen werden kann; und (3.) ein Verfahren, bei dem zunächst eine formaldehydfreie Proteinlösung und danach eine Formaldehydlösung aufgetragen wird, wobei die zweite Lösung vor oder nach dem Trocknen der ersten aufgetragen werden kann. Für die Behandlung des Proteins mit Formaldehyd kann gegebenenfalls ein saurer Katalysator, z. B. Essigsäure oder Ameisensäure, zugesetzt werden. Die Reaktion zwischen dem Protein und dem Formaldehyd erfolgt ohne weiteres. Im allgemeinen kommt es während des Trocknens nach dem Beschichten zu einer ausreichenden Reaktion, bei der eine Vernetzung des Proteins mit dem Formaldehyd stattfindet. Dabei reagiert der Formaldehyd mit einem aktiven Wasserstoffatom einer -CONH-Gruppe des Proteins, wobei zunächst eine N-Methylol-Gruppe und dann eine Gruppe des Typs $N-CH_2-N$ entsteht. Wenn das Protein vor dem Einfärben mit Formaldehyd umgesetzt wird, wird das Verhältnis von Formaldehyd zu Protein so gewählt, daß der Formaldehyd mit einem Teil der im Protein enthaltenen -CONH-Gruppen reagieren kann. Im allgemeinen wird der Grad, bis zu dem das protein mit Formaldehyd umgesetzt wird, durch die größte zulässige Quellung der Schicht und das erforderliche Mindestmaß an Farbaufziehvermögen bestimmt. Als Lösemittel für das Protein wird normalerweise Wasser oder ein Gemisch aus Wasser und einem Alkohol, z. B. Methanol oder Ethanol, verwendet. Für die Behandlung mit Formaldehyd ist nicht nur Formaldehyd selbst geeignet; es kann auch eine Verbindung verwendet werden, die Formaldehyd freizusetzen vermag, z. B. Paraformaldehyd. Das Aufbringen der mit Formaldehyd behandelten Proteinschicht kann auf verschiedene Art erfolgen, z. B. durch Sprühen, Aufschleudern, durch Walzenantrag oder durch Rakeln, wobei mit Aufschleudern die besten Ergebnisse erreicht werden.

Anschließend wird auf die in der beschriebenen Weise erzeugte, mit Formaldehyd behandelte Proteinschicht eine Photoresistschicht aufgetragen. Für die Photoresistschicht wird ein herkömmliches positiv arbeitendes Photoresistmaterial verwendet.

Im Rahmen der vorliegenden Erfindung wird der vorstehend beschriebene Verbund, der aus einem Träger mit einer mit Formaldehyd behandelten Proteinschicht und einer darüber aufgebrachten Photoresistschicht besteht, zunächst bildmäßig belichtet und entwickelt, wobei die darunterliegende mit Formaldehyd behandelte Proteinschicht bildmäßig freigelegt wird. Die dermaßen bildmäßig freigelegte Proteinschicht wird anschließend eingefärbt. Dafür sind alle Farbmittel geeignet, mit deren Hilfe die -CONH-Gruppe des Proteins gefärbt werden kann, z. B. saure Farbstoffe. Der Färbevorgang, für den eine Vielzahl bekannter Farbstoffe verwendet werden können, wird in bekannter Weise durchgeführt. So wird auf der Oberfläche des Verbunds ein farbiges Bild in einer ersten Farbe erzeugt. Erfindungsgemäß können auf die beschriebene Art nacheinander Bilder in anderen Farben erzeugt werden. Es wird also die Photoresistschablone, die auf der Oberfläche des Verbunds verblieben ist, der in der beschriebenen Weise mit dem farbigen Bild der ersten Farbe versehen wurde, nach dem ersten Einfärben der Proteinschicht nochmals belichtet und entwickelt. Danach werden die erneut freigelegten Bereiche der Proteinschicht mit einem gewünschten Bild einer zweiten Farbe eingefärbt. Anschließend wird die nun noch verbleibende Photoresistschicht erneut bildmäßig belichtet und entwickelt. Danach wird die Proteinschicht bildmäßig in einer dritten Farbe eingefärbt.

Bei einer zweiten Ausführungsform des erfindungsgemäßen Verfahrens wird für die Herstellung einer farbigen Reproduktion ein Verbund verwendet, der aus einem Träger besteht, auf dem sich eine Proteinschicht und über dieser eine Photoresistschicht befinden. Dabei können als Träger, Protein und Photoresist die vorstehend genannten Materialien eingesetzt werden. Bei der Durchführung des zweiten Verfahrens wird der beschriebene Verbund aus Träger, unbehandelter Proteinschicht und Photoresistschicht zunächst in gewünschter Weise bildmäßig belichtet und entwickelt, so daß die unter der Photoresistschicht liegende Proteinschicht entsprechend diesem Bild freigelegt wird. Die solcherart bildmäßig freigelegte Proteinschicht wird anschließend mit Formaldehyd behandelt. Für die Behandlung mit Formaldehyd wird eine Formaldehyd enthaltende Lösung eingesetzt, die durch Lösen von Formaldehyd oder einer Substanz, die Formaldehyd freisetzt, z. B. von paraformaldehyd, erhalten wird. Im vorliegenden Fall wird ein wäßriges Lösemittel meistens Wasser, benutzt. In einigen Fällen kann auch ein Alkohol, z. B. Methanol oder Ethanol, oder ein Lösemittelgemisch aus Wasser und Alkohol verwendet werden. Als Formaldehyd enthaltende Lösung eignet sich Formalin (wäßrige Formaldehydlösung von etwa 40 %) oder eine verdünntere Formaldehydlösung. Die Behandlung mit Formaldehyd erfolgt z. B. durch Beschichten oder Tauchen und wird normalerweise bei Temperaturen zwischen 30 und 100°C durchgeführt. Gegebenenfalls kann auch ein saurer Katalysator, z. B. Essigsäure oder Ameisensäure, zugesetzt werden.

Bei der beschriebenen Behandlung mit Formaldehyd reagiert dieser mit dem aktiven Wasserstoffatom von (in der freigelegten Proteinschicht enthaltenen) -CONH-Gruppen, so daß über -Methylol-Gruppen eine dreidimensionale Vernetzung unter Bildung von N-CH$_2$-N-Gruppen erfolgt. Wird für die Behandlung mit Formaldehyd eine Lösung von Formaldehyd in Methanol verwendet, findet eine Nebenreaktion statt, bei der N-Methoxymethylgruppen gebildet werden. Das Vorhandensein der N-Methoxymethylgruppen in der Proteinschicht verursacht jedoch keine Probleme. Es genügt, wenn die Oberfläche der Proteinschicht mit Formaldehyd behandelt wird, d. h. es braucht nicht immer die gesamte Schicht umgesetzt zu werden. Die Behandlung der freigelegten Proteinschicht mit Formaldehyd wird so durchgeführt, daß ein Teil der in der Proteinschicht enthaltenen -CONH-Gruppen wie beschrieben reagiert.

An die Behandlung der freigelegten Proteinschicht mit Formaldehyd schließt sich eine Einfärbung an, die wie oben beschrieben durchgeführt wird und bei der in der Oberfläche des Verbunds ein farbiges Bild in einer ersten Farbe entsteht. Gegebenenfalls können erfindungsgemäß auf die gleiche Weise farbige Bilder in einer zweiten und dritten Farbe hergestellt werden. Das heißt, die Oberfläche des Verbunds, der das farbige Bild der ersten Farbe trägt, wird in analoger Weise noch einmal belichtet, entwickelt, mit Formaldehyd behandelt und gefärbt, so daß ein gewünschtes Bild in einer zweiten Farbe erhalten wird. Durch eine nochmalige Wiederholung der beschriebenen Schritte wird ein gewünschtes Bild einer dritten Farbe erzeugt.

Nach der dritten oben erwähnten Verfahrensweise wird ein Verbund, der aus einem Schichtträger, einer unumgesetzten Proteinschicht und einer Photoresistschicht besteht, zuerst bildmäßig belichtet und entwickelt, wobei die Proteinschicht bildmäßig freigelegt wird. Danach wird diese in der beschriebenen Weise eingefärbt und anschließend mit Formaldehyd behandelt. Wie oben beschrieben, können weitere Farben durch nochmaliges Belichten, Entwickeln, Einfärben und Behandeln mit Formaldehyd zugefügt werden. Gegebenenfalls kann die letzte Formaldehydbehandlung fortgelassen werden. Diese Verfahrensweise kann mit einzelnen Stufen der ersten oder zweiten Verfahrensweise kombiniert werden. So kann das Quellvermögen oder die Löslichkeit der Proteinschicht in einem Lösungsmittel jeweils vor dem Einfärben durch eine vorhergehende Behandlung mit Formaldehyd herabgesetzt oder ganz beseitigt werden.

Gemäß einer Ausführungsform des erfindungsgemäßen Verfahrens wird die Proteinschicht nach der Erzeugung eines Bilds in einer ersten Farbe und vor der Erzeugung eines weiteren farbigen Bildes mit Formaldehyd behandelt, um die -CONH-Gruppen der Proteinschicht durch Umsetzen mit Formaldehyd zu desaktivieren, so daß sie nicht mehr angefärbt werden können. Dann kann beim nächsten Einfärbeschritt das bereits vorhandene farbige Bild nicht mehr in einer anderen Farbe eingefärbt werden, auch wenn keine Schutzschicht aufgebracht worden ist.

Im Gegensatz zu herkömmlichen Verfahren ist es erfindungsgemäß somit nicht erforderlich, jedesmal eine Schutzschicht aufzubringen, bevor auf einer gefärbten Proteinschicht ein weiteres farbiges Bild erzeugt wird. Das einmalige Auftragen einer Photoresistschicht genügt, da unter denjenigen Stellen der Photoresistschicht, an denen eine Einfärbung stattfinden soll, die Proteinschicht erst gefärbt wird, nachdem die Photoresistschicht an diesen Stellen durch Belichtung und Entwicklung entfernt worden ist. Danach werden die jeweils freigelegten Stellen der Proteinschicht in der gewünschten Farbe eingefärbt.

Es kann also durch wiederholtes Belichten, Entwickeln, Einfärben und ggf. Behandeln mit Formaldehyd jede gewünschte farbige Reproduktion hergestellt werden. Mit Hilfe der vorliegenden Erfindung ist es daher möglich, die Anzahl der Schritte für die Herstellung einer farbigen Reproduktion erheblich zu verringern. Wenn die Proteinschicht vor dem Einfärben mit Formaldehyd behandelt wird, kann es nicht zu einem Anquellen oder Anlösen dieser Schicht beim Einfärben kommen, und es ist auf diese Weise möglich, eine farbige Reproduktion mit einem klaren mehrfarbigen Bild hoher Auflösung zu erhalten.

Das erfindungsgemäße Verfahren ist besonders für die Herstellung farbiger Reproduktionen zur Verwendung für Flüssigkristallanzeigeelemente geeignet. Dabei ermöglicht die Verwendung einer positiv arbeitenden Photoresistschicht die Herstellung farbiger Reproduktionen hoher Auflösung.

Die Erfindung wird anhand der folgenden Beispiele näher erläutert, in denen Teile, Mengenverhältnisse und Prozentzahlen in Gewichtseinheiten zu verstehen sind, wenn nichts anderes angegeben ist.

Beispiel 1

10 Teile Gelatine wurden in Wasser von 80°C gelöst. Zu dieser Lösung wurde warmes Wasser, das 1 Teil Paraformaldehyd enthielt, gegeben, so daß 60 Teile einer warmen Gelatine-Formaldehyd-Lösung erhalten wurden. Die warme wäßrige Lösung wurde auf eine Glasplatte aufgeschleudert und zu einer Schicht von 5μm Dicke getrocknet. Die Gelatineschicht wurde mit einer Positivphotoresistlösung aus

6 g des Veresterungsprodukts aus 1,2-Naphthochinon-2-diazid-4-sulfonylchlorid und 4-(2-Phenyl-prop-2-yl)phenol und

20 g eines Kresol-Formaldehyd-Novolaks mit einem Erweichungsbereich von 105-120°C in

74 g 2-Methoxy-ethanol

durch Aufschleudern beschichtet und anschließend erhitzt, durch proximitybelichtung bebildert und mit einer üblichen wäßrig-alkalischen Lösung entwickelt, wobei ein Bild mit Linienbreiten bis 30μm erhalten wurde. Der erhaltene Verbund wurde zum Färben 5 Minuten in eine auf 60°C erwärmte wäßrige Lösung getaucht, die 0,1 % eines sauren roten Farbstoffs enthielt (Lanapearl Scarlet G; C.I. 14 690). Während des Färbens konnte keinerlei Verformung des Resists durch Anquellen der darunterliegenden Gelatineschicht festgestellt werden. Der Verbund wurde getrocknet; danach wurde der unbelichtete Teil der photoresistschicht erneut belichtet und entwickelt, so daß auf der mit Formaldehyd behandelten Proteinschicht ein Bild mit Linienbreiten von 30μm erhalten wurde.

Der Verbund wurde danach zum Färben in eine wäßrige Lösung von 50°C getaucht, die 0,1 % eines sauren gelben Farbstoffes enthielt (Alphanol Fast Brilliant Yellow F 333; C.I. 22 910). Der zuvor rot gefärbte Teil nahm die gelbe Farbe nicht an. Auf dem Träger wurde ein klares zweifarbiges, rot-gelbes Bild erhalten.

Beispiel 2

Eine Glasplatte wurde durch Aufschleudern mit einer Gelatineschicht versehen, und darüber wurde ohne vorheriges Trocknen die wäßrige Gelatine-Formaldehyd-Lösung aus Beispiel 1 aufgeschleudert, so daß eine mit Formaldehyd behandelte Gelatineschicht einer Trockenschichtdicke von 20 μm erhalten wurde.

Danach wurde die Gelatineschicht mit der in Beispiel 1 angegebenen Photoresistlösung schleuderbeschichtet. Nach dem Erhitzen wurde der Verbund belichtet und entwickelt, wobei ein Bild mit einer Linienbreite von 20 μm erhalten wurde.

Anschließend wurde das Bild 5 Minuten bei 60°C in die in Beispiel 1 angegebene rote Farbstofflösung getaucht. Während des Färbens konnte keine Deformierung der Photoresistschicht festgestellt werden. Danach wurde ein Teil der verbliebenen Photoresistschablone belichtet und entwickelt, so daß auf der mit Formaldehyd behandelten Gelatineschicht ein Bild einer Linienbreite von 9 μm erhalten wurde. Dieses Bild wurde wie in Beispiel 1 beschrieben gelb gefärbt, wobei ein klares zweifarbiges rot-gelbes Bild erhalten wurde.

Beispiel 3

Auf eine Glasplatte wurde zunächst eine 5μm dicke Gelatineschicht aufgebracht und darüber eine positiv arbeitende Photoresistschicht der in Beispiel 1 angegebenen Zusammensetzung aufgeschleudert, die erhitzt, belichtet und entwickelt wurde. Dabei wurde auf der Gelatineschicht ein Bild mit Linienbreiten von 40 μm erzeugt. Das auf diese Weise erhaltene Produkt wurde dann mit einer wäßrigen Formalinlösung beschichtet und mit Hilfe einer erwärmten Platte 5 Minuten auf 85°C erhitzt. Der erhaltene Verbund wurde 5 Minuten bei 60°C in die rote Farbstofflösung von Beispiel 1 getaucht. Während des Färbens konnte keine Quellung bzw. Deformierung der Photoresistschicht festgestellt werden. Anschließend wurde ein weiterer Teil der Photoresistschablone belichtet und entwickelt, wobei ein Bild mit einer Linienbreite von 40 μm entstand. Es folgten eine in der vorstehend beschriebenen Weise durchgeführte Behandlung mit Formaldehyd und das Einfärben mit dem gelben Farbstoff von Beispiel 1, wobei ein klares zweifarbiges, rot-gelbes Bild erhalten wurde.

Beispiel 4

Auf eine Glasplatte wurde eine 5μm dicke Gelatineschicht aufgetragen und darüber eine positiv arbeitende Photoresistschicht der in Beispiel 1 angegebenen Zusammensetzung aufgeschleudert. Die Photoresistschicht wurde erhitzt, belichtet und entwickelt, wobei auf der Gelatineschicht ein Bild einer Linienbreite von 30 μm erzeugt wurde. Die mit dem Bild versehene Photoresistschicht wurde mit einer wäßrigen Formalinlösung beschichtet, die eine katalytische Menge Ameisensäure enthielt, und mit Hilfe einer beheizten Platte 5 Minuten auf 85°C erwärmt. Der erhaltene Verbund wurde 5 Minuten bei 60°C in die rote Farbstofflösung von Beispiel 1 getaucht. Während des Färbens konnte keine Deformierung der Photoresistschicht festgestellt werden. Anschließend wurde ein weiterer Teil der Photoresistschablone belichtet und entwickelt, wobei auf der Gelatineschicht ein Bild einer Linienbreite von 30 μm entstand. Es wurde dann in der vorstehend beschriebenen Weise mit Formaldehyd behandelt und mit dem gelben Farbstoff von Beispiel 1 eingefärbt, wobei ein klares zweifarbiges, rot-gelbes Bild erhalten wurde.

Beispiel 5

Eine 5μm dicke Gelatineschicht wurde auf eine Glasplatte aufgebracht, worauf eine Schicht aus der in Beispiel 1 angegebenen Photoresistlösung aufgeschleudert, erhitzt, belichtet und entwickelt wurde. Es wurde ein Bild mit einer Linienbreite von 40 μm erhalten. Das erhaltene Bild wurde 5 Minuten bei 50°C in die in Beispiel 1 angegebene rote Farbstofflösung getaucht. Das bebilderte produkt wurde dann mit Formalinlösung behandelt, die eine katalytische Menge Essigsäure enthielt, und 5 Minuten auf einer erhitzten Platte auf 85°C erwärmt. Die verbliebene Photoresistschablone wurde dann nochmals belichtet und entwickelt, wobei ein Reliefbild von 40 μm Linienbreite erhalten wurde. Das erhaltene Produkt wurde bei 50°C 5 Minuten in die in Beispiel 1 angegebene gelbe Farbstofflösung getaucht. Die zuvor rot gefärbten Schichtbereiche der Gelatineschicht nahmen keinen gelben Farbstoff an. Ein klares zweifarbiges gelb-rotes Bild wurde erhalten.

Beispiel 6
(Vergleichsbeispiel)

Auf einer Gelatineschicht wurde wie in Beispiel 4 beschrieben ein Bild erzeugt. Es wurde anschließend 5 Minuten bei 60°C in die in Beispiel 1 angegebene Farbstofflösung getaucht, jedoch nicht mit Formalin behandelt. Bei der mikroskopischen Untersuchung wurden in den Randbereichen der roten Linien Risse festgestellt.

**Patentansprüche**

1. Verfahren zur Herstellung eines mehrfarbigen Bilds, bei dem ein lichtempfindliches Material aus einem Schichtträger, einer proteinschicht und einer positiv arbeitenden Photoresistschicht, die auf der Proteinschicht liegt, bildmäßig belichtet und durch Auswaschen der belichteten Bereiche der Photoresistschicht entwickelt wird, die freigelegten Bereiche der Proteinschicht mit einer Farbstofflösung eingefärbt werden, die verbliebene Photoresistschablone mindestens ein weiteres Mal bildmäßig belichtet und entwickelt wird und die hierbei freigelegten Bereiche der Proteinschicht mit einer Lösung eines anderen Farbstoffs eingefärbt werden, dadurch gekennzeichnet, daß das Protein entweder vor dem Aufbringen oder nach dem Entwickeln der Photoresistschicht und vor dem Einfärben oder aber nach dem Einfärben mit Formaldehyd oder einer Formaldehyd freisetzenden Verbindung behandelt wird.

2. Verfahren nach Anspruch 1, dadurch gekennzeichnet, daß man die Formaldehydbehandlung bei einer Temperatur im Bereich von 30 bis 100°C durchführt.

3. Verfahren nach Anspruch 1, dadurch gekennzeichnet, daß man eine Formaldehydlösung verwendet, der ein saurer Katalysator zugesetzt worden ist.

4. Verfahren nach Anspruch 1, dadurch gekennzeichnet, daß man als Protein Gelatine einsetzt.

5. Verfahren nach Anspruch 1, dadurch gekennzeichnet, daß man die Behandlung mit Formaldehyd vor dem Einfärben durchführt.

6. Verfahren nach Anspruch 1, dadurch gekennzeichnet, daß man jeweils zwischen zwei Färbeschritten eine Formaldehydbehandlung vornimmt.

7. Lichtempfindliches Material zur Durchführung des Verfahrens gemäß Anspruch 1, dadurch gekennzeichnet, daß es aus einem Schichtträger besteht, der eine mit Formaldehyd behandelte Proteinschicht und darüber eine positiv arbeitende Photoresistschicht trägt.

**Revendications**

1. Procédé pour la production d'une image polychrome, dans lequel on expose selon l'image un matériau photosensible constitué d'un support de couches, d'une couche de protéine et d'une couche de photoresist travaillant en positif qui se trouve sur la couche de protéine, on le développe par élimination par lavage des zones exposées de la couche de photoresist, on colore à l'aide d'une solution de colorant les zones mises à nu de la couche de protéine, on expose selon l'image et développe au moins encore une fois le masque de photoresist restant puis on colore avec une solution d'un autre colorant les zones ainsi mises à nu de la couche de protéine, caractérisé en ce que, soit avant l'application, soit après le développement de la couche de photoresist et avant la coloration ou bien après la coloration, on traite la protéine par du formaldéhyde ou par un composé libérant du formaldéhyde.

2. Procédé selon la revendication 1, caractérisé en ce que l'on effectue le traitement par le formaldéhyde à une température dans la plage de 30 à 100°C.

3. Procédé selon la revendication 1, caractérisé en ce que l'on utilise une solution de formaldéhyde à laquelle a été ajouté un catalyseur acide.

4. Procédé selon la revendication 1, caractérisé en ce que l'on utilise de la gélatine en tant que protéine.

5. Procédé selon la revendication 1, caractérisé en ce que l'on effectue le traitement par le formaldéhyde avant la coloration.

6. Procédé selon la revendication 1, caractérisé en ce que l'on effectue chaque fois un traitement par le formaldéhyde entre deux étapes de coloration.

7. Matériau photosensible pour la mise en oeuvre du procédé selon la revendication 1, caractérisé en ce qu'il est constitué d'un support de couches qui porte une couche de protéine traitée par le formaldéhyde et, sur celle-ci, une couche de photoresist travaillant en positif.

**Claims**

1. Process for producing multicolour reproduction in which a photosensitive material composed of a film base, a protein film and a positive-working photoresist film which is situated on the protein film is exposed to an image and developed by washing out the exposed regions of the photoresist film, the regions of the protein film uncovered being dyed with a dye stuff solution, the remaining photoresist template being exposed to an image and developed at least one more time and the regions of the protein film uncovered in the process being dyed with a solution of another dye stuff, characterized in that the protein is treated with formaldehyde or a compound which releases formaldehyde, either before the deposition of or after the development of the photoresist film and before the dyeing, or alternatively, after the dyeing.

2. Process according to Claim 1, characterized in that the formaldehyde treatment is carried out at a temperature in the range extending from 30 to 100°C.

3. Process according to Claim 1, characterized in that a formaldehyde solution is used to which an acidic catalyst has been added.

4. Process according to Claim 1, characterized in that gelatine is used as protein.

5. Process according to Claim 1, characterized in that the treatment with formaldehyde is carried out before the dyeing.

6. Process according to claim 1, characterized in that a formaldehyde treatment is always carried out between two dyeing steps.

7. Photosensitive material for carrying out the process according to Claim 1, characterized in that it is composed of a film base which supports a protein film treated with formaldehyde and a positive-working photoresist film on top of the latter.